(19) Europäisches Patentamt
European Patent Office
Office européen des brevets

(11) **EP 1 955 110 B1**

(12) **FASCICULE DE BREVET EUROPEEN**

(45) Date de publication et mention de la délivrance du brevet:
**14.05.2014 Bulletin 2014/20**

(21) Numéro de dépôt: **06819692.2**

(22) Date de dépôt: **23.11.2006**

(51) Int Cl.:
***G03F 1/24*** *(2012.01)*

(86) Numéro de dépôt international:
**PCT/EP2006/068793**

(87) Numéro de publication internationale:
**WO 2007/063021 (07.06.2007 Gazette 2007/23)**

(54) **MASQUE DE PHOTOLITHOGRAPHIE EN EXTREME ULTRA-VIOLET, A CAVITES ABSORBANTES**

EXTREM-ULTRAVIOLETT-FOTOLITHOGRAFIEMASKE MIT ABSORBIERENDEN HOHLRÄUMEN

EXTREME ULTRAVIOLET PHOTOLITHOGRAPHY MASK, WITH ABSORBENT CAVITIES

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **02.12.2005 FR 0512255**

(43) Date de publication de la demande:
**13.08.2008 Bulletin 2008/33**

(73) Titulaire: **Commissariat à l'Énergie Atomique et aux Énergies Alternatives**
**75015 Paris (FR)**

(72) Inventeur: **CONSTANCIAS, Christophe**
**F-38000 Grenoble (FR)**

(74) Mandataire: **Guérin, Michel**
**Marks & Clerk France**
**Conseils en Propriété Industrielle**
**Immeuble Visium**
**22, Avenue Aristide Briand**
**94117 Arcueil Cedex (FR)**

(56) Documents cités:
**FR-A1- 2 884 965          JP-A- 2002 313 694**
**JP-A- 2004 095 980     US-A1- 2003 027 053**
**US-A1- 2004 142 250     US-A1- 2005 147 894**
**US-B1- 6 589 717          US-B1- 6 593 037**

## Description

L'invention concerne la photolithographie, et notamment la photolithographie aux très courtes longueurs d'onde. Elle concerne plus précisément une structure de masque de lithographie en extrême ultraviolet destiné à être utilisé en réflexion.

La photolithographie est utilisée pour la réalisation de microstructures électroniques, optiques, mécaniques, ou des microstructures combinant des fonctions électroniques et/ou optiques et/ou mécaniques. Elle consiste à insoler par un rayonnement photonique, à travers un masque qui définit le motif souhaité, une couche de résine photosensible déposée sur un substrat plan (par exemple une tranche de silicium). Le développement chimique qui suit l'insolation révèle les motifs souhaités dans la résine. Le motif de résine ainsi gravé peut servir à plusieurs usages, le plus commun étant la gravure d'une couche sous-jacente (isolante ou conductrice ou semiconductrice) pour définir dans cette couche un motif identique à celui de la résine.

On cherche à obtenir des motifs extrêmement petits et précis et à aligner très précisément des motifs gravés dans de multiples couches superposées. Typiquement, la dimension critique des motifs souhaités est aujourd'hui d'une fraction de micromètre, voire même un dixième de micromètre et au-dessous. La longueur d'onde de la lumière utilisée dans l'opération de photolithographie limite la résolution ; plus elle est courte plus les motifs peuvent être fins. La photolithographie en ultraviolet (longueurs d'onde descendant jusqu'à 193 nanomètres) permet de faire des motifs plus fins qu'avec de la lumière visible.

On cherche aujourd'hui à descendre très largement au-dessous de ces longueurs d'onde et à travailler en extrême ultraviolet (EUV), à des longueurs d'onde comprises entre 10 et 14 nanomètres. Le but est d'obtenir une très haute résolution, tout en gardant une ouverture numérique faible et une profondeur de champ suffisante (quelques centaines de nanomètres).

Mais à ces longueurs d'onde les matériaux formant le substrat du masque ne sont pas transparents et l'opération de photolithographie doit utiliser des masques fonctionnant en réflexion et non en transmission : la lumière en extrême ultraviolet est projetée sur le masque sous une faible incidence (5 à 6 degrés environ) ; le masque comporte des zones absorbantes et des zones réfléchissantes ; dans les zones réfléchissantes, le masque réfléchit la lumière sur la résine à exposer, en y imprimant son image. Le trajet de la lumière entre le masque et la résine à exposer passe par d'autres réflecteurs dont les géométries sont conçues pour projeter une image réduite du masque et non une image en grandeur réelle. La réduction d'image permet de graver sur la résine exposée des motifs plus petits que ceux qui sont gravés sur le masque.

Le masque lui-même est fabriqué à partir d'un procédé de photolithographie puis d'une gravure avec un masque de résine ou d'un masque dur (par exemple en silice, nitrure de silicium, chrome), cette fois en transmission et avec une longueur d'onde plus grande, autorisée par le fait que les motifs sont plus grands.

Typiquement, un masque en réflexion de type masque binaire est composé d'un substrat plan recouvert d'une structure réfléchissante continue, en pratique un miroir de Bragg c'est-à-dire une structure à multiples couches diélectriques d'indices de réfraction différents dont les épaisseurs sont calculées en fonction des indices, de la longueur d'onde, et de l'angle d'incidence, pour que les différentes interfaces, partiellement réfléchissantes, renvoient des ondes lumineuses en phase les unes avec les autres ; ce miroir est recouvert d'une couche absorbante gravée selon le motif de masquage désiré, de sorte que le masque comprend des zones réfléchissantes (le miroir non recouvert d'absorbant) et des zones absorbantes (le miroir recouvert d'absorbant). A titre d'exemple, pour une longueur d'onde de 13,5 nm et un angle d'incidence de 6 degrés, on atteint une réflectivité de 74% avec 40 couches de silicium d'épaisseur 41,5 angströms (1 angström = 0,1 nm) alternées avec 40 couches de molybdène d'épaisseur 28 angströms. Les zones absorbantes peuvent être constituées de chrome (entre autres) déposé sur le miroir ; par exemple une couche de 600 angströms de chrome placée sur le miroir ci-dessus ne réfléchit plus que 1 % de la lumière incidente.

Parmi les inconvénients de cette structure de masque, il y a notamment le fait que les zones absorbantes sont épaisses (plusieurs centaines de nanomètres), d'où il résulte un ombrage non négligeable des transitions entre zones absorbantes et réfléchissantes en présence d'un éclairement oblique même faible (6°), donc une perte de résolution.

On a proposé également de réaliser les zones absorbantes en creusant localement la surface du miroir et en remplissant l'ouverture par une couche absorbante. L'effet d'ombrage est diminué, mais le procédé est très complexe. L'article "Design and Method of Fabricating Phase Shift Masks for Extreme Ultraviolet Lithography by Partial Etching into the EUV Multilayer Mirror", Sang-In Han et autres, dans Proceedings of SPIE vol 5037 (2003), décrit une telle structure.

On a proposé encore des structures de masques dits "masques EUV-PSM" (PSM pour "Phase Shift mask", signifiant masque à déphasage en anglais). On creuse des ouvertures dans le miroir pour réduire localement son épaisseur d'une valeur telle que la lumière réfléchie dans les zones d'épaisseur réduite soit en opposition de phase avec la lumière réfléchie dans les zones d'épaisseur non réduite. Cela crée à la frontière des interférences destructrices qui constituent l'équivalent de zones absorbantes. Si le coefficient de réflexion R2 dans les zones d'épaisseur réduite reste proche du coefficient de réflexion R1 dans les zones d'épaisseur non réduite (par exemple R2 égal à 85% ou plus de R1) on parle de masque H-PSM pour "Hard PSM masks"). Si l'un des coefficients de réflexion est nettement plus faible que l'autre, on parle de masque A-PSM pour "Attenuated Phase Shift Mask".

Il existe aussi des masques dits Alt-PSM ou masques PSM alternés, dans lesquels deux zones réfléchissantes proches sont séparées par une zone absorbante, les deux zones réfléchissantes successives produisant des réflexions en opposition de phase, ce qui garantit le passage systématique par zéro, dans une zone absorbante, de l'intensité lumineuse réfléchie.

Le document JP 2004 095980 A décrit un masque de photolithographie en extrême ultraviolet fonctionnant en réflexion (Mo/Si) comportant une structure multicouche réfléchissante et un motif gravé selon un motif à reproduire où l'épaisseur d'une couche de silicium prend des valeurs différentes de manière à former des cavités optiques résonantes absorbantes de type Fabry-Pérot.

Le document JP 2002 313694 A décrit un masque similaire, avec la possibilité d'inverser le contraste par un changement d'épaisseur, les zones de silicium devenant alors réfléchissantes et les zone de molybdène devenant absorbantes.

Toutes ces structures de masques sont complexes et donc coûteuses à réaliser avec précision, ou bien elles créent un relief important sur la surface (donc des ombrages en présence d'éclairement obliques), en particulier du fait de l'épaisseur d'absorbant nécessaire dans les zones sombres.

L'invention a pour but de proposer une structure de masque améliorée par rapport aux structures de masques de la technique antérieure, du point de vue du compromis entre les performances et le coût de réalisation.

A cet effet, l'invention propose un masque de photolithographie en extrême ultra-violet, fonctionnant en réflexion, comportant un substrat, une structure réfléchissante multicouche déposée sur le substrat et un motif gravé selon une image à reproduire, caractérisé en ce que le motif gravé est défini par la présence de cavités optiques résonantes absorbantes de type Fabry-Pérot, comprenant un milieu transparent situé entre un miroir inférieur et un miroir supérieur partiellement transparent, le milieu transparent de la cavité comportant au moins une couche d'un matériau différent des matériaux constituant la structure réfléchissante multicouche.

Le miroir inférieur est de préférence constitué directement par la structure multicouche réfléchissante déposée sur le substrat.

Le masque comporte alors un motif de zones réfléchissantes (la structure réfléchissante là où il n'y a pas de cavité résonante absorbante) et de zones absorbantes (les cavités résonantes absorbantes au-dessus de la structure réfléchissante).

Le fait que le matériau de la cavité soit différent du matériau de la structure réfléchissante multicouche rend possible en pratique la réalisation de telles cavités, qui seraient très difficiles à réaliser si le matériau de la cavité était le même que celui des miroirs. On choisira de préférence comme matériau différent un matériau qui a de bonnes propriétés de sélectivité de gravure vis-à-vis des couches de la structure réfléchissante.

Un avantage important de l'invention est qu'on peut de cette manière, comme on l'expliquera en détail plus loin, réaliser des zones absorbantes juxtaposées à des zones réfléchissantes avec un très faible relief à la surface du masque, donc un ombrage très réduit lors de l'illumination en incidence oblique : quelques dizaines d'angströms de relief au lieu de plusieurs centaines d'angströms, tout en ayant un fort contraste de réflexion entre zones absorbantes et zones réfléchissantes. En effet, l'épaisseur d'une cavité résonante absorbante peut être beaucoup plus faible que celle d'une simple couche absorbante.

Une cavité résonante de type Fabry-Pérot est constituée de deux miroirs, l'un au moins étant partiellement transparent, séparés par une certaine distance optique dans la direction de traversée de la lumière, et un espace transparent (c'est-à-dire parfaitement transparent ou peu absorbant) entre les miroirs. Par distance optique, on entend ici la somme des différentes distances optiques élémentaires dans chacun des milieux optiques successivement traversés par la lumière, chacune de ces distances optiques élémentaires étant le produit de la distance physique dans la direction de parcours de la lumière par l'indice de réfraction du milieu traversé. La cavité est résonante si la lumière directement réfléchie sur le miroir supérieur est en déphasage d'un multiple de 180° avec la lumière qui sort du miroir supérieur après un aller-retour dans la cavité incluant une réflexion sur le miroir inférieur. Si c'est un multiple impair de 180°, la cavité est absorbante en ce sens que les multiples réflexions engendrent des interférences destructives du fait qu'elles produisent des rayons en déphasage mutuel de 180° après des trajets aller-retour dans la cavité. Si c'est un multiple pair, la cavité résonante est réfléchissante, la lumière issue de multiples réflexions dans la cavité engendrant des ondes en phase avec la réflexion principale donc des interférences constructives. Cette situation de résonance peut être obtenue avec une faible distance entre miroirs (de l'ordre de 40 angströms, pour des longueurs d'onde autour de 135 angströms.

L'espace séparant les miroirs est rempli d'un ou plusieurs matériaux transparents ou peu absorbants, l'un au moins étant différent des matériaux du miroir inférieur. Par conséquent, dans ce qui suit, le mot "cavité" est pris au sens d'une cavité "optique" ; ce mot ne désigne donc pas un espace vide dépourvu de matériau de remplissage.

Les miroirs d'une cavité résonante, miroir inférieur comme miroir supérieur, peuvent être des structures multicouches de type miroir de Bragg, la structure réfléchissante multicouche déposée uniformément sur le miroir étant un tel miroir de Bragg.

Le miroir supérieur de la cavité qui, en utilisation, est situé du côté de l'entrée d'un rayonnement incident, est partiellement transparent ; l'autre est de préférence fortement réfléchissant.

La quantité de lumière réfléchie à la longueur d'onde d'utilisation dépend de l'épaisseur d de la cavité, de l'angle d'incidence θ de la lumière, de l'indice de propagation du matériau contenu dans la cavité (indice complexe, n, k où n est l'indice de réfraction et k le coefficient d'atténuation), et bien sûr des coefficients de réflexion et de transmission des miroirs de la cavité.

L'épaisseur du milieu transparent, entre les deux miroirs, pour une cavité absorbante est, selon la théorie, un multiple impair du quart de la longueur d'onde, divisée par l'indice de réfraction n et par le cosinus de l'angle d'incidence θ de la lumière EUV en utilisation. C'est la condition pour que la distance optique correspondant à un aller-retour de la lumière dans l'espace situé entre les miroirs provoque un déphasage de 180° par rapport à la réflexion principale.

Dans une première réalisation les cavités sont réalisées avec deux couches de matériaux différents superposées entre les deux miroirs. La couche inférieure peut être présente à la fois dans les cavités et hors des cavités, c'est-à-dire à la fois dans les zones absorbantes et dans les zones réfléchissantes du masque. C'est de préférence au moins cette couche inférieure qui est en matériau différent des matériaux de la structure réfléchissante multicouche. Elle est de préférence peu attaquée par les produits de gravure des matériaux servant à constituer le miroir supérieur.

Le miroir supérieur s'étend de préférence non seulement au-dessus des cavités mais aussi en dehors de l'emplacement des cavités, au-dessus de la structure réfléchissante multicouche déposée sur le substrat ; en effet, en constituant le miroir supérieur comme le miroir inférieur, c'est-à-dire à l'aide d'une structure multicouche de Bragg, la superposition des structures réfléchissantes multicouches du miroir inférieur et du miroir supérieur, là où il n'y a pas de cavité absorbante interposée entre les miroirs, constitue elle-même une structure réfléchissante.

Dans une deuxième réalisation, des cavités résonantes absorbantes sont juxtaposées à des cavités résonantes réfléchissantes pour constituer le motif gravé de zones absorbantes et réfléchissantes ; la structure réfléchissante multicouche déposée sur le substrat constitue une paroi réfléchissante inférieure pour les deux types de cavité ; un miroir supérieur partiellement transparent est formé au-dessus des cavités absorbantes et des cavités réfléchissantes.

De préférence, l'épaisseur du milieu situé entre le miroir supérieur et le miroir inférieur est alors la même pour les deux types de cavité, les matériaux constituant le milieu transparent des cavités ayant des indices de réfraction différents et l'épaisseur du milieu ayant une valeur telle que la courbe de variation de la réflectivité des cavités absorbantes en fonction de l'épaisseur présente un pic d'absorption au voisinage de cette valeur d'épaisseur, alors que la réflectivité des cavités réfléchissantes est d'au moins 50% pour cette valeur.

D'autres caractéristiques et avantages de l'invention apparaîtront à la lecture de la description détaillée qui suit et qui est faite en référence aux dessins annexés dans lesquels :

- la figure 1 représente schématiquement le principe d'une cavité résonante de type Fabry-Pérot fonctionnant en mode réflectif ;
- la figure 2 représente des courbes de réflectance, transparence, et absorption typiques d'une structure de miroir multicouche ;
- la figure 3 représente des courbes de réflectivité d'une cavité de Fabry-Pérot en fonction de la distance d séparant les deux miroirs de la cavité ;
- la figure 4 représente des courbes de nombre optimal de couches de la structure de miroir supérieur de la cavité en fonction du coefficient d'atténuation du milieu situé entre les deux miroirs ;
- la figure 5 représente le principe d'un masque binaire avec une cavité vide ou remplie d'air ;
- la figure 6 représente une réalisation de l'invention dans laquelle la cavité est remplie par un matériau transparent ;
- la figure 7 représente une réalisation semblable à la figure 6, mais dans laquelle le matériau remplissant la cavité est constitué par la superposition de deux couches de matériaux différents ;
- la figure 8 représente une réalisation semblable à la figure 7, mais dans laquelle la couche inférieure de la superposition s'étend non seulement dans la cavité mais aussi à l'extérieur de la cavité ;
- la figure 9 représente une réalisation dans laquelle les zones réfléchissantes et les zones absorbantes du masque sont constituées par des cavités résonantes de type Fabry-Pérot produisant des interférences constructives et des interférences destructives respectivement ;
- la figure 10 représente une courbe de réflectivité expliquant le principe des réalisations telles que celles de la figure 9.

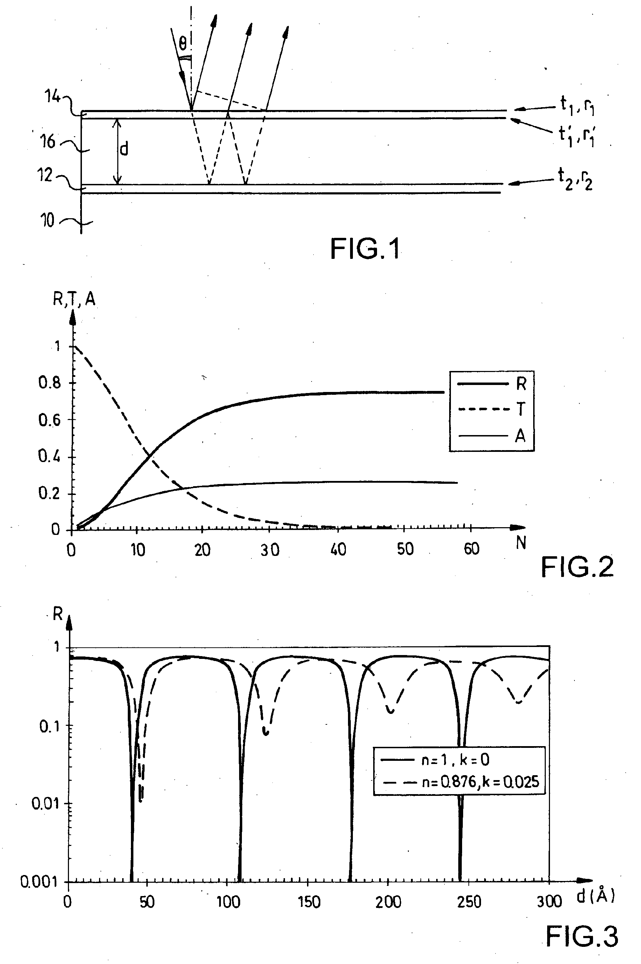

Sur la figure 1, on rappelle le principe d'une cavité résonante de Fabry-Pérot, fonctionnant en mode réflectif, le rayonnement de sortie de la cavité étant du même côté de la cavité que le rayonnement d'entrée.

On voit un substrat 10 sur lequel on a déposé un miroir inférieur supposé parfaitement réfléchissant 12, puis un miroir supérieur 14, partiellement réfléchissant et partiellement transparent, séparé du premier par une distance d, l'espace 16 entre les deux miroirs étant vide ou rempli d'un matériau transparent ou peu absorbant d'indice de réfraction n.

Les rayons lumineux incidents traversent le miroir supérieur 14 et la cavité, puis retraversent la cavité et le miroir après réflexion sur le miroir inférieur 12. La longueur du chemin optique suivi par les rayons est alors fonction de la distance d, de l'indice n, et de l'angle d'incidence θ.

Le coefficient de réflexion global dépend des coefficients de transmission et de réflexion à chaque interface, à savoir t1, r1 à l'interface entre le miroir supérieur 14 et le milieu extérieur, t'1, r'1 à l'interface entre le miroir 14 et la cavité, et t2, r2 à l'interface entre la cavité et le miroir inférieur.

La cavité est résonante et absorbante si les réflexions multiples engendrent des interférences destructives, c'est-à-dire si les rayons réfléchis après un aller-retour dans la cavité sont en déphasage de 180° (un multiple impair d'une demi-longueur d'onde) avec les rayons qui sont directement réfléchis sans passer par la cavité. La condition de résonance en absorption maximale impose alors une épaisseur d de cavité qui est :

$$d = (2m+1)\lambda/4n\cos\theta$$

m est un entier, $\lambda$ est la longueur d'onde, $\theta$ est l'angle d'incidence de la lumière.

Au contraire, la cavité est résonante et réfléchissante si les réflexions multiples engendrent des interférences constructives, c'est-à-dire si les rayons réfléchis après un aller-retour dans la cavité sont en déphasage de 360° (un multiple pair d'une demi-longueur d'onde) avec les rayons qui sont directement réfléchis sans passer par la cavité. La condition de résonance en réflexion maximale impose alors une épaisseur d de cavité qui est :

$$d = 2m\lambda/4n\cos\theta$$

Des courbes de réflectivité en fonction de l'épaisseur à longueur d'onde fixée ou de longueur d'onde d'utilisation à épaisseur fixée présentent alors des pics de réflectivité et des pics d'absorption alternés représentant la résonance en réflexion et la résonance en absorption respectivement.

Ces valeurs de condition de résonance sont des valeurs théoriques, les valeurs expérimentales pouvant être légèrement différentes, sans que le principe reste changé, en fonction notamment de la constitution des miroirs. En particulier, les miroirs peuvent être constitués par des structures multicouches de Bragg et les conditions pour obtenir la résonance doivent en tenir compte car on ne peut pas considérer que la réflexion dans un miroir multicouche se produit exactement à la surface de la couche supérieure. Pour simplifier les explications on supposera quand-même que la distance entre les miroirs est régie par les formules ci-dessus pour obtenir la résonance.

La réflectivité et la transparence des structures multicouches dépendent du nombre de couches. La figure 2 représente à titre d'exemple les courbes de réflectivité et de transparence de structures à couches de silicium (41,5 angströms) et de molybdène (28 angströms) alternées pour une longueur d'onde de 13,5 nanomètres (préférée selon l'invention) et un angle d'incidence de 6°, en fonction du nombre N de paires de couches. La réflectivité R, la transparence T et l'absorption A sont représentées. On constate que la réflectivité et la transparence sont à peu près égales pour N=12 paires de couches ; on peut réaliser le miroir supérieur 14 avec 12 paires de couches si on veut qu'il soit réfléchissant à 50%.

Dans la suite, les données numériques seront fondées sur un choix de 13,5 nanomètres pour la longueur d'onde et 6° pour l'angle d'incidence.

La figure 3 représente la réflectivité R de l'ensemble de la cavité de Fabry-Pérot, en fonction de la distance d, lorsque la cavité est réalisée avec un miroir supérieur semi-transparent à 12 paires de couches Si(41,5 angströms)Mo(28 angströms), et avec un miroir inférieur à 30 paires de couches (mêmes épaisseurs). Ces miroirs sont des miroirs de Bragg et les épaisseurs 41,5 et 28 angströms sont des épaisseurs qui correspondent à des déphasages optiques multiples d'une demi-longueur d'onde en tenant compte des indices optiques différents des deux matériaux, et en tenant compte de l'angle d'incidence prévu (6°), afin que les couches multiples jouent le rôle de miroir en établissant des réflexions multiples toutes en phase à la sortie du miroir.

Sur la figure 3 on a représenté deux courbes :

- l'une en traits pleins avec une cavité vide ou remplie d'air (indice 1, atténuation 0) ;
- l'autre en traits tiretés avec une cavité supposée remplie d'un matériau peu absorbant supposé avoir un indice de propagation n=0,876, k=0,025.

On constate que la structure de la figure 1 présente des pics d'absorption (réflexion très faible) pour certaines valeurs de la distance d. Ils se traduiraient par des pics d'absorption pour la longueur d'onde d'utilisation si on traçait les courbes en fonction de l'épaisseur d en fonction de la longueur d'onde.

Ces pics sont plus marqués lorsque le milieu de la cavité a une atténuation k nulle (courbe en traits pleins). Ils sont moins marqués mais ils existent quand même lorsqu'il y a une atténuation dans la cavité (courbe en traits tiretés). Dans le cas qui est représenté, et qui correspond à un miroir supérieur de 12 couches, le premier pic est alors le plus important, les suivants sont de moins en moins marqués ; mais avec un autre nombre de couches du miroir supérieur la situation pourrait être différente. Dans l'exemple représenté sur la courbe en traits tiretés, la réflectivité n'est plus que de 1 % au creux du pic, alors qu'elle est d'environ 70% entre les pics.

On constate aussi que la distance d donnant lieu à un pic peut-être faible (environ 40 angströms pour le premier pic, 100 angströms pour le deuxième). On notera enfin que la position des pics est décalée vers la droite si l'indice de réfraction n diminue puisque la distance d qui donne lieu à résonance absorbante est inversement proportionnelle à n.

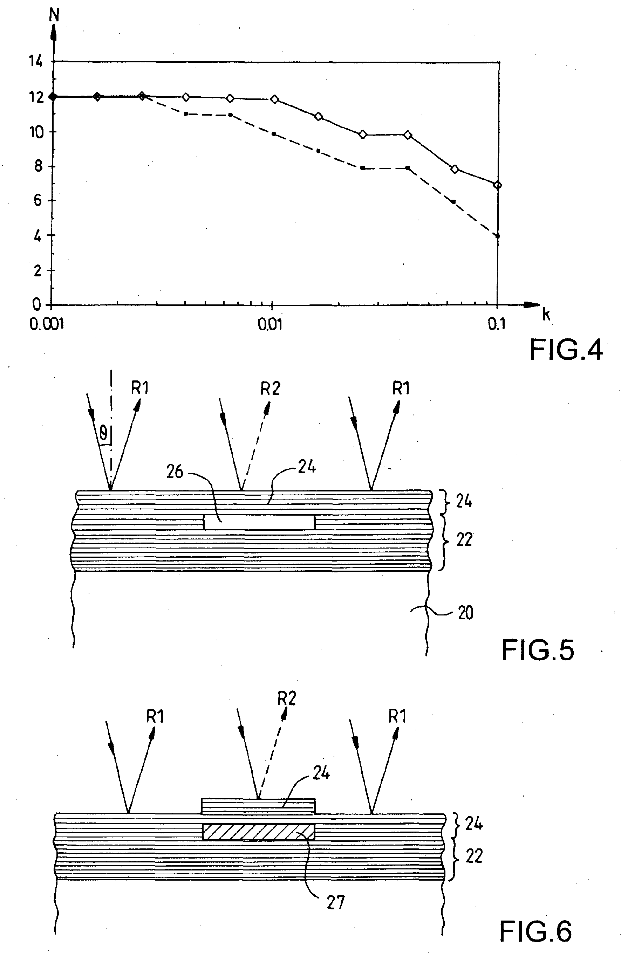

On a essayé par ailleurs de voir quelle était l'influence du coefficient d'atténuation k du matériau de la cavité sur la profondeur du pic d'absorption, et on a constaté que pour avoir un pic d'absorption suffisamment profond même avec des coefficients d'atténuation non nuls, il pouvait être utile de modifier le nombre de paires de couches du miroir supérieur. La courbe de la figure 4 montre le nombre de paires de couches optimal pour avoir un pic avec réflectivité inférieure à 1%, en fonction de k. Par exemple, pour k = 0,03, le nombre de couches optimal est plutôt égal à 10 (courbe en traits pleins). La courbe en traits pleins de la figure 4 correspond au premier pic d'absorption (vers 45 angströms) dans le type de courbe représenté à la figure 3. La courbe en traits tiretés de la figure 4 correspond au deuxième pic (vers 120 angströms).

Partant de ces observations, on constitue un masque dont les zones réflectives sont des zones de miroir multicouche classique, mais dont les zones non réfléchissantes sont constituées à l'aide de cavités optiques résonantes calculées pour produire des pics d'absorption profonds.

Dans l'exemple de la figure 5, le plus simple d'un point de vue théorique, la cavité est vide ou remplie d'air ; l'indice est 1 et l'atténuation nulle ou négligeable. Le masque comprend un substrat 20 sur lequel est déposé un miroir inférieur uniforme 22 très réfléchissant constitué de préférence par au moins 30 paires de couches alternées Si(41,5 angströms)/Mo(28 angströms) et un miroir supérieur 24 partiellement transparent de 12 paires de couches qui, avantageusement pour simplifier la technologies, sont identiques aux paires du miroir inférieur. Ces valeurs numériques sont liés au choix d'une longueur d'onde préférée de 13,5 nanomètres et d'un angle d'incidence préféré d'environ 6° qu'on adopte pour tous les exemples donnés dans cette description. Avec une autre longueur d'onde et un autre angle d'incidence, il faudrait choisir d'autres valeurs pour respecter la condition de Bragg et obtenir des miroirs réfléchissants.

D'une façon générale, l'homme du métier déterminera les épaisseurs des couches de l'empilement en utilisant la loi de Bragg.

Dans les zones de masque qui doivent être absorbantes on a ménagé un espace 26 d'épaisseur proche de 40 angströms entre le miroir inférieur et le miroir supérieur ; cette épaisseur de 40 angströms correspond au premier pic d'absorption de la courbe en traits plein de la figure 3. La réflectivité R1 de la superposition directe des miroirs 22 et 24 est très élevée (voisine de 75%), en raison des 42 paires de couches identiques superposées. La réflectivité R2 de la structure avec cavité résonante constituée par l'espace 26 entre les miroirs est très faible (inférieure à 0,1 %) du fait qu'on s'est placé dans le pic d'absorption de la cavité. On notera conformément à ce qui a été dit ci-dessus que, en raison de l'utilisation de miroirs multicouches. la distance d entre miroirs n'est pas tout à fait obtenue par la formule d=λ/4ncosθ qui donnerait plutôt 34 angströms.

Dans la pratique on réalisera des cavités qui ne sont pas vides ni remplies d'air, mais des cavités remplies d'un matériau solide, car la réalisation en est plus facile et il existe des matériaux très transparents aux EUV. On notera qu'une cavité vide peut être réalisée en déposant d'abord le miroir supérieur puis en déposant et gravant à la forme de la cavité un matériau de remplissage provisoire, puis en déposant le miroir supérieur, et enfin en retirant par des ouvertures latérales le matériau provisoire. Il faut pour cela que le matériau de remplissage puisse être gravé sans détériorer les couches qui composent les miroirs.

La figure 6 représente une réalisation dans laquelle la cavité est formée à partir d'un matériau transparent 27 d'une épaisseur d'environ 40 angströms si l'indice du matériau est très proche de 1, ou d'une épaisseur différentes si l'indice s'éloigne de 1. Le miroir inférieur 22 a encore 30 paires de couches alternées Si(41,5 angströms)/Mo(28 angströms). Le miroir supérieur 24 a 12 paires de couches alternées identiques à celles du miroir 22. Il recouvre aussi bien le matériau 27 là où il est présent que le miroir inférieur 22 là où le matériau 27 n'est pas présent. La réflectivité R1 dans les régions où il n'y a pas le matériau 27 est élevée (de l'ordre de 75%) du fait des 42 paires de couches identiques superposées. La réflectivité R2 là où il y a le matériau 27 est très faible si l'épaisseur est choisie de manière à former une cavité résonante absorbante.

Le matériau qu'on choisira devra répondre aux critères suivants : très faible absorption, et surtout facilité de gravure sélective par rapport aux matériaux (molybdène et silicium) qui composent la structure multicouche inférieure. L'oxyde de silicium peut convenir.

On voit que le relief introduit à la surface du masque entre les zones réfléchissantes (réflectivité R1) et les zones absorbantes (réflectivité R2) est très faible puisque la différence de hauteur est égale à l'épaisseur du milieu 27 de la cavité, typiquement environ 40 angströms. Le phénomène d'ombrage est très réduit de ce fait.

La réalisation du masque de la figure 6 est particulièrement simple puisqu'elle consiste à déposer le miroir inférieur multicouche, puis à déposer une couche de matériau 27, puis à graver cette couche pour la laisser subsister seulement dans les zones qui doivent être absorbantes, et enfin à déposer uniformément le miroir supérieur sans qu'il soit nécessaire de le graver.

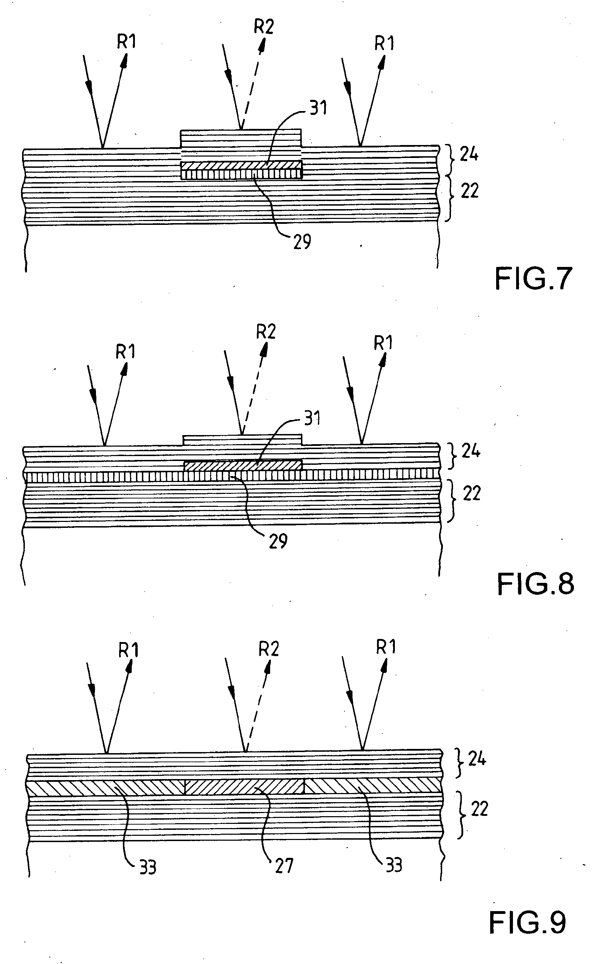

La figure 7 représente une réalisation dans laquelle le milieu qui sépare les deux miroirs de la cavité est constitué par deux couches de matériaux différents, tous deux transparents ou faiblement absorbants à la longueur d'onde d'utilisation. La superposition de couches transparentes entre deux miroirs se comporte encore comme une cavité optique, qui est résonante et présente un pic d'absorption si la distance optique parcourue par la lumière en aller-retour à travers les deux couches répond aux conditions de résonance indiquées plus haut (fondées sur des trajets optiques qui sont des multiples impairs de la longueur d'onde).

L'intérêt de cette double couche est principalement l'aide à la gravure des motifs réfléchissants et absorbants du masque même si la deuxième couche de cette superposition est du silicium (ou du molybdène). On choisira en effet comme couche inférieure 29 une couche tampon qui constitue une couche d'arrêt de gravure lorsqu'on grave la couche supérieure 31 pour définir le motif de cavités. Cette couche tampon n'est pas ou pratiquement pas attaquée par le produit de gravure de la couche supérieure, et de plus il est souhaitable qu'elle puisse elle-même être attaquée par un produit de gravure qui n'attaque pas la surface du miroir inférieur 22 du masque. L'oxyde de silicium convient bien.

Dans l'exemple de la figure 7, le procédé de fabrication comprend le dépôt uniforme des couches du miroir inférieur 22 (par exemple 30 paires de couches Si/Mo), puis le dépôt uniforme des couches 29 et 31, puis la gravure de la couche 31 pour définir les emplacements des cavités résonantes absorbantes, puis l'enlèvement de la couche 29 là où elle n'est plus protégée par la couche 31. Puis, on dépose uniformément les couches (par exemple 12 paires de couches Si/Mo) du miroir supérieur 24, aussi bien en dehors des cavités résonantes qu'au-dessus des cavités. La couche inférieure 29 peut être en oxyde de silicium, avec une épaisseur d'environ 20 angströms ; la couche supérieure 31 peut-être en silicium d'épaisseur 21 angströms (avec de préférence un miroir supérieur 24 à 13 couches), ou en chrome d'épaisseur environ 23 angströms (avec de préférence un miroir supérieur à 10 paires de couches Si/Mo). Le dépôt de cette double couche nécessite donc des étapes supplémentaires par rapport au procédé décrit à propos de la figure 6 (dépôt de la couche 29 avant la couche 31, puis enlèvement de cette couche 29 après gravure de la couche 31), mais on évite d'endommager le miroir inférieur.

Dans la réalisation de la figure 8, on n'enlève pas la couche inférieure 29 après gravure de la couche 31 ; elle subsiste donc et on dépose le miroir supérieur 24 uniformément, aussi bien au-dessus de la couche 29 en dehors des îlots de couche 31 qu'au-dessus des îlots de couche 31. La couche 29 n'a donc pas besoin dans ce cas de pouvoir être gravée par un produit n'attaquant pas le miroir inférieur 22.

On notera que dans la réalisation de la figure 8, la différence de marche entre les zones réfléchissantes et les zones absorbantes peut être encore plus faible que dans les réalisations des figures 6 et 7 puisqu'elle se limite à l'épaisseur de la couche 31, par exemple 20 angströms. L'ombrage en est d'autant réduit lors de l'utilisation.

Cette disposition peut présenter l'inconvénient de diminuer légèrement la réflectivité R1 du masque dans les zones réfléchissantes, mais la surface du miroir inférieur 24 est mieux protégée puisqu'elle reste recouverte par une fine couche d'oxyde de silicium. On peut minimiser la perte de réflectivité R1 dans la zone réfléchissante en donnant à la couche 29 elle-même une épaisseur qui établirait une cavité résonante réfléchissante (trajet optique multiple pair d'un quart de longueur d'onde) dans la superposition miroir inférieur 22/couche 29/miroir supérieur 24. On aura alors une réflectivité globale située au niveau d'un pic de réflectivité pour la longueur d'onde d'utilisation, malgré la présence de la couche tampon. Typiquement dans ce cas l'épaisseur de la couche 29 serait d'environ 75 à 80 angströms pour une couche tampon en oxyde de silicium. L'épaisseur de la couche 31 serait alors de l'ordre de 40 angströms et non 20 pour que l'empilement de la couche 31 et de la couche 29 continue à satisfaire à la condition de pic d'absorption là où il y a les îlots 31.

La figure 9 représente une autre réalisation dans laquelle on utilise une cavité résonante absorbante pour définir les zones sombres du masque binaire (faible réflectivité R2), on utilise une cavité résonante réfléchissante (forte réflectivité R1) pour définir les zones réfléchissantes du masque, et on réduit de préférence à zéro la différence de marche entre les zones sombres et les zones réfléchissantes en utilisant des cavités de même épaisseur pour ces zones. Pour y parvenir, il faut choisir des matériaux d'indices de réfraction différents tels que pour la même épaisseur d, la condition de résonance absorbante (interférences destructives) s'applique pour l'une des cavités et la condition de résonance réfléchissante (interférences constructives) s'applique pour l'autre. Puisque l'une des conditions repose sur le fait que d est proportionnel à (2m+1) et l'autre sur le fait que d est proportionnel à 2m, il faut que les indices n et n' des matériaux choisis soient dans un rapport 2m/2m+1 ou 2m/2m-1 où m est un entier.

Or on peut trouver des couples de matériaux qui répondent à ces critères, et vérifier expérimentalement les valeurs d'épaisseur d qu'il faut choisir pour que cette épaisseur commune conduise bien à un fort contraste entre zones réfléchissantes et zones absorbantes. Un même miroir supérieur 24, uniformément déposé, recouvre alors les deux types de cavités qui par ailleurs utilisent le même miroir inférieur 22.

Il est particulièrement intéressant de constater qu'alors il n'y a plus de marche entre les zones sombres (cavités remplies d'un premier matériau 27) et les zones réfléchissantes (cavités remplies d'un matériau 33), donc aucun effet d'ombrage, et que de plus la phase de la lumière dans les zones réfléchissantes est globalement opposée à la phase de la lumière dans les zones absorbantes, ce qui fait qu'on réalise un masque qui possède à la fois les propriétés d'un masque fortement binaire (réflexions R1 et R2 très contrastées) et les propriétés d'un masque à décalage de phase (transition abrupte avec interférences destructrices dans la zone de transition).

Là encore, le matériau de la cavité absorbante devra comporter selon l'invention au moins une couche d'un matériau différent des matériaux de la structure multicouche réfléchissante, et de préférence un matériau qui peut être gravé par un produit qui n'attaque pas la structure multicouche.

Des exemples peuvent être donnés pour des matériaux qui conviennent :

Par exemple, si m=3, il faut deux matériaux dont les indices soient à peu près dans un rapport 7/6 ou 5/6 ; c'est le cas pour le couple silicium/palladium à la longueur d'onde de 13,5 nanomètres : le rapport est presque 7/6. on peut avoir un masque ayant des zones de silicium fortement réfléchissantes et des zones de palladium fortement absorbantes ; en effet, avec une épaisseur de 6 fois $\lambda/4n\cos\theta$ pour le silicium (m=3) et une épaisseur de 5 fois $\lambda/4n\cos\theta$ pour le palladium (m=2), soit environ 200 angströms on obtient la condition de résonance absorbante pour le palladium et réfléchissante pour le silicium. C'est la même chose avec une épaisseur d'environ 277 angströms m=4 pour le silicium et m=3 pour le palladium.

Ces valeurs numériques doivent être confrontées aux résultats expérimentaux, et elles dépendent de la constitution du miroir supérieur : en effet, le nombre de couches du miroir supérieur doit être ajusté en fonction de la nature des matériaux utilisés pour les cavités résonantes. Dans le dernier exemple ci-dessus, le miroir supérieur est à 4 paires de couches.

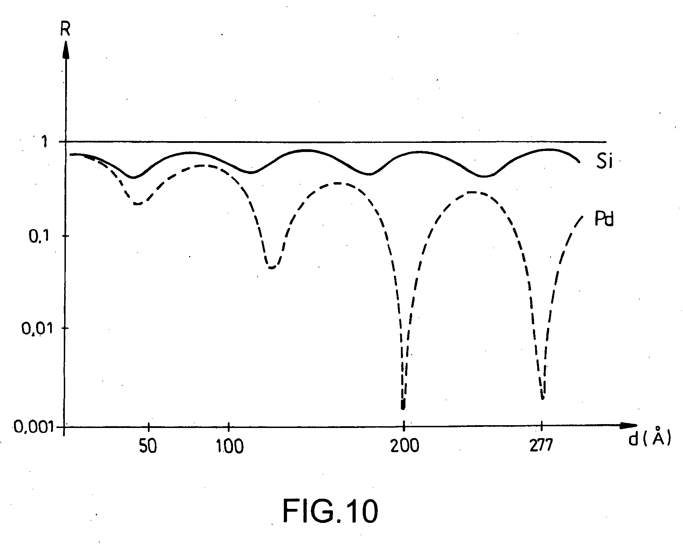

A titre d'exemple, la figure 10 représente des courbes de réflectivité de cavités résonantes réalisées de la manière suivante : miroir inférieur comme précédemment : 30 paires de couches Mo(28 angströms)/Si(41,5 angströms); milieu de la cavité en silicium (courbe en trait continu) ou en palladium (courbe en traits tiretés) ; miroir supérieur constitué de 4 paires de couches alternées Si/Mo. Les courbes sont tracées en fonction de l'épaisseur d de la cavité.

Ces courbes montrent que les pics d'absorption de la cavité en palladium sont de plus en plus marqués lorsque l'épaisseur d croît et qu'il existe deux pics d'absorption très importants pour des épaisseurs de cavité de 200 angströms et de 277 angströms. Et pour ces épaisseurs, la réflectivité de la cavité de silicium (qui varie un peu en fonction de l'épaisseur) est plutôt en valeur haute (environ 70% à 75%). On peut donc réaliser un masque avec des cavités alternées de silicium (réfléchissantes) et de palladium (absorbantes) d'épaisseur 200 ou 277 angströms, et un miroir supérieur avec un petit nombre de paires de couches (de préférence 4 ou 5 paires Mo/Si).

Plus généralement, il faut sélectionner des matériaux qui ont des indices dans des rapports 2m/(2m+1) ou 2m/(2m-1). Ainsi par exemple le titane pour le premier matériau et l'argent, le platine ou le ruthenium pour l'autre matériau, avec une valeur de m = 7 et une épaisseur commune d'environ 535 angströms, car le rapport entre les indices de ces matériaux est de 14/15. Dans ce cas, les zones avec du titane deviennent zones absorbantes.

On peut également donner l'exemple de couples suivants : premier matériau (zones absorbantes) : W, NbO, Cr, Nb ; deuxième matériau (zones réfléchissantes) : Ru, Ag, Pt ; rapport d'indices 20/21 (m=10) ; épaisseur commune : environ 765 angströms.

La fabrication d'un masque conforme à la figure 9 comprend alors les étapes suivantes : dépôt uniforme des couches successives du miroir inférieur 22, puis dépôt d'un premier matériau servant à l'un des types de cavités, par exemple le matériau 27 qui définit les cavités absorbantes ; puis gravure du matériau 27 (à ce sujet, le matériau 27 peut être constitué de plusieurs couches 29, 31 comme expliqué en référence aux figures 7 et 8 si cela facilite la gravure) ; puis dépôt du matériau 33 du deuxième type de cavité ; enlèvement par érosion mécanique et chimique des surépaisseurs formées par le matériau 33 là où il recouvre le matériau 27, jusqu'à faire affleurer ce dernier et obtenir une surface plane où les couches 27 et 33 ont la même épaisseur ; et enfin dépôt uniforme des couches du miroir supérieur 24 sur la surface plane uniforme des couches 27 et 33.

On ainsi décrit des masques fonctionnant en réflexion en extrême ultraviolet, améliorés du point de vue de l'effet d'ombrage.

**Revendications**

1. Masque de photolithographie en extrême ultra-violet, fonctionnant en réflexion, comportant un substrat (20), une structure réfléchissante multicouche (22) déposée sur le substrat et un motif gravé selon une image à reproduire, **caractérisé en ce que** le motif gravé est défini par la présence de cavités optiques résonantes absorbantes de type Fabry-Pérot, chaque cavité comprenant un milieu transparent (26) situé entre un miroir inférieur réfléchissant et un miroir supérieur (24) partiellement transparent, et le milieu transparent de la cavité comprenant au moins une couche d'un matériau différent des matériaux constituant la structure réfléchissante multicouche.

2. Masque selon la revendication 1, **caractérisé en ce que** la structure réfléchissante multicouche (22) constitue le miroir inférieur des cavités.

3. Masque selon la revendication 2, **caractérisé en ce que** le miroir supérieur (24) est une deuxième structure multicouche, de type miroir de, Bragg.

4. Masque de photolithographie selon l'une des revendications 1 à 3, **caractérisé en ce que** ladite couche de matériau différent possède des propriétés de sélectivité de gravure par rapport aux couches constituant la structure réfléchissante multicouche.

5. Masque de photolithographie selon l'une des revendications 1 à 4, **caractérisé en ce que** ladite couche de matériau différent est une couche d'oxyde de silicium.

**6.** Masque de photolithographie selon l'une des revendications 1 à 5, **caractérisé en ce que** le milieu transparent de la cavité résonante est constitué par la superposition d'au moins deux couches de matériaux différents transparents ou peu absorbants (29, 31), sur lesquelles repose le miroir supérieur (24), la couche inférieure étant ladite couche de matériau différent des matériaux de la structure réfléchissante.

**7.** Masque de photolithographie selon la revendication 6, **caractérisé en ce que** la couche inférieure (29) de la superposition de couches constituant le milieu transparent (26) de la cavité s'étend au-dessus de la structure réfléchissante multicouche (22) déposée sur le substrat, à la fois dans les cavités et en dehors des cavités.

**8.** Masque de photolithographie selon la revendication 7, **caractérisé en ce que** l'épaisseur de la couche inférieure (29) de la superposition est choisie telle que la superposition du miroir inférieur, de la couche inférieure, et du miroir supérieur forme une cavité résonante réfléchissante de Fabry-Pérot présentant un pic de réflectivité pour la longueur d'onde d'utilisation.

**9.** Masque de photolithographie selon l'une des revendications 1 à 6, **caractérisé en ce que** dans les zones réfléchissantes, le miroir supérieur (24) est directement superposé au miroir inférieur (22).

**10.** Masque de photolithographie selon l'une des revendications 6 à 9, **caractérisé en ce que** les deux couches comprennent une couche d'oxyde de silicium inférieure et une couche de silicium ou de chrome supérieure.

**11.** Masque de photolithographie selon l'une des revendications 1 à 8 ou 10, **caractérisé en ce qu'**il comporte un motif gravé constitué par des cavités résonantes absorbantes (27) juxtaposées à des cavités résonantes réfléchissantes (33); la structure réfléchissante (22) déposée sur le substrat constituant une paroi inférieure pour ces cavités, et un même miroir supérieur partiellement transparent (24) étant formé au-dessus des cavités absorbantes et des cavités réfléchissantes.

**12.** Masque de photolithographie selon la revendication 11, **caractérisé en ce que** l'épaisseur (d) du milieu situé entre le miroir supérieur et le miroir inférieur est la même pour les.deux types de cavité, les matériaux constituant le milieu transparent des cavités ayant des indices de réfraction différents et l'épaisseur ayant une valeur telle que la courbe de variation de la réflectivité des cavités absorbantes en fonction de l'épaisseur présente un pic d'absorption au voisinage de cette valeur, la réflectivité des cavités réfléchissantes étant d'au moins 50% pour cette valeur.

**Patentansprüche**

**1.** Fotolithografiemaske im extremen Ultraviolett, die mit Reflexion arbeitet und Folgendes umfasst: ein Substrat (20), eine auf dem Substrat angeordnete reflektierende Mehrschichtstruktur (22) und ein geätztes Muster gemäß einem zu reproduzierenden Bild, **dadurch gekennzeichnet, dass** das geätzte Muster durch die Anwesenheit von optischen absorbierenden Resonanzhohlräumen des Fabry-Pérot-Typs definiert wird, wobei jeder Hohlraum ein transparentes Medium (26) umfasst, das sich zwischen einem reflektierenden unteren Spiegel und einem teiltransparenten oberen Spiegel (24) befindet, wobei das transparente Medium des Hohlraums wenigstens eine Schicht aus einem Material umfasst, das sich von den Materialien unterscheidet, die die reflektierende Mehrschichtstruktur bilden.

**2.** Maske nach Anspruch 1, **dadurch gekennzeichnet, dass** die reflektierende Mehrschichtstruktur (22) den unteren Spiegel der Hohlräume bildet.

**3.** Maske nach Anspruch 2, **dadurch gekennzeichnet, dass** der obere Spiegel (24) eine zweite Mehrschichtstruktur des Bragg-Spiegeltyps ist.

**4.** Fotolithografiemaske nach einem der Ansprüche 1 bis 3, **dadurch gekennzeichnet, dass** die unterschiedliche Materialschicht Ätzselektivitätseigenschaften in Bezug auf die Schichten besitzt, die die reflektierende Mehrschichtstruktur bilden.

**5.** Fotolithografiemaske nach einem der Ansprüche 1 bis 4, **dadurch gekennzeichnet, dass** die unterschiedliche Materialschicht eine Siliciumoxidschicht ist.

**6.** Fotolithografiemaske nach einem der Ansprüche 1 bis 5, **dadurch gekennzeichnet, dass** das transparente Medium des Resonanzhohlraums von der Übereinanderschichtung von wenigstens zwei Schichten aus unterschiedlichen transparenten und schlecht absorbierenden Materialien (29, 31) gebildet wird, auf denen der obere Spiegel (24) ruht, wobei die untere Schicht die Materialschicht ist, die sich von den Materialien der reflektierenden Struktur unterscheidet.

**7.** Fotolithografiemaske nach Anspruch 6, **dadurch gekennzeichnet, dass** die untere Schicht (29) der Übereinanderschichtung von das transparente Medium (26) des Hohlraums bildendenden Schichten sich über der auf dem Substrat angeordneten reflektierenden Multischichtstruktur (22) gleichzeitig in den Hohlräumen und außerhalb der Hohlräume erstreckt.

8. Fotolithografiemaske nach Anspruch 7, **dadurch gekennzeichnet, dass** die Dicke der unteren Schicht (29) der Übereinanderschichtung so gewählt ist, dass die Übereinanderschichtung des unteren Spiegels, der unteren Schicht und des oberen Spiegels einen reflektierenden Fabry-Pérot-Resonanzhohlraum bildet, der eine Reflexionsgradspitze für die Nutzungswellenlänge bietet.

9. Fotolithografiemaske nach einem der Ansprüche 1 bis 6, **dadurch gekennzeichnet, dass** der obere Spiegel (24) in den reflektierenden Zonen direkt auf dem unteren Spiegel (22) überlagert ist.

10. Fotolithografiemaske nach einem der Ansprüche 6 bis 9, **dadurch gekennzeichnet, dass** die beiden Schichten eine untere Siliciumoxidschicht und eine obere Silicium- oder Chromschicht umfassen.

11. Fotolithografiemaske nach einem der Ansprüche 1 bis 8 oder 10, **dadurch gekennzeichnet, dass** sie ein geätztes Motiv umfasst, das von den absorbierenden Resonanzhohlräumen (27) in Nebeneinanderlage an den reflektierenden Resonanzhohlräumen (33) gebildet wird, wobei die auf dem Substrat deponierte reflektierende Struktur (22) eine untere Wand für diese Hohlräume bildet und wobei ein gleicher teiltransparenter oberer Spiegel (24) oberhalb der absorbierenden Hohlräume und der reflektierten Hohlräume ausgebildet ist.

12. Fotolithografiemaske nach Anspruch 11, **dadurch gekennzeichnet, dass** die Dicke (d) des Mediums, das sich zwischen dem oberen Spiegel und dem unteren Spiegel befindet, für die beiden Hohlraumtypen gleich ist, wobei die das transparente Medium der Hohlräume bildenden Materialien unterschiedliche Brechungsindexe haben und wobei die Dicke einen solchen Wert hat, dass die Variationskrümmung des Reflexionsgrades der absorbierenden Hohlräume in Abhängigkeit von der Dicke eine Absorptionsspitze in der Nähe dieses Wertes hat, wobei der Reflexionsgrad der reflektierenden Hohlräume wenigstens 50 % für diesen Wert beträgt.

**Claims**

1. An extreme ultraviolet photolithography mask operating in reflection, comprising a substrate (20), a multilayer reflecting structure (22) deposited on the substrate and a pattern etched according to an image to be reproduced, **characterized in that** the etched pattern is defined by the presence of absorbent resonant optical cavities of the Fabry-Pérot type, each cavity comprising a transparent medium (26) located between a reflecting lower mirror and a partially transparent upper mirror (24), and the transparent medium of the cavity comprising at least one layer of a material different from the materials constituting the multilayer reflecting structure.

2. The mask as claimed in claim 1, **characterized in that** the multilayer reflecting structure (22) constitutes the lower mirror of the cavities.

3. The mask as claimed in claim 2, **characterized in that** the upper mirror (24) is a second multilayer structure of the Bragg mirror type.

4. The photolithography mask as claimed in one of claims 1 to 3, **characterized in that** said layer of different material possesses properties of being etch-selective with respect to the layers constituting the multilayer reflecting structure.

5. The photolithography mask as claimed in one of claims 1 to 4, **characterized in that** said layer of different material is a silicon oxide layer.

6. The photolithography mask as claimed in one of claims 1 to 5, **characterized in that** the transparent medium of the resonant cavity is formed by the superposition of at least two transparent or weakly absorbent layers of different materials (29, 31) on which the upper mirror (24) rests, the lower layer being said layer of material different from the materials of the reflecting structure.

7. The photolithography mask as claimed in claim 6, **characterized in that** the lower layer (29) of the superposition of layers making up the transparent medium (26) of the cavity extends on top of the multilayer reflecting structure (22) deposited on the substrate, both in the cavities and outside the cavities.

8. The photolithography mask as claimed in claim 7, **characterized in that** the thickness of the lower layer (29) of the superposition is chosen in such a way that the superposition, of the lower mirror, the lower layer and the upper mirror, forms a Fabry-Pérot reflecting resonant cavity having a reflectivity peak for the operating wavelength.

9. The photolithography mask as claimed in one of claims 1 to 6, **characterized in that**, in the reflecting zones, the upper mirror (24) is superposed directly on the lower mirror (22).

10. The photolithography mask as claimed in one of claims 6 to 9, **characterized in that** the two layers comprise a silicon oxide lower layer and a silicon or chromium upper layer.

11. The photolithography mask as claimed in one of claims 1 to 8 or 10, **characterized in that** it includes an etched pattern formed by absorbent resonant cavities (27) juxtaposed with reflecting resonant cavities (33), the reflecting structure (22) deposited on the substrate constituting a lower wall for these cavities, and one and the same partially transparent upper mirror (24) being formed on top of the absorbent cavities and the reflecting cavities.

12. The photolithography mask as claimed in claim 11, **characterized in that** the thickness (d) of the medium located between the upper mirror and the lower mirror is the same for both types of cavity, the materials making up the transparent medium of the cavities having different refractive indices and the thickness having a value such that the curve of variation of the reflectivity of the absorbent cavities as a function of the thickness has an absorption peak close to this value, the reflectivity of the reflecting cavities being at least 50% for this value.

FIG.1

FIG.2

FIG.3

FIG.4

FIG.5

FIG.6

FIG.7

FIG.8

FIG.9

14

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2004095980 A

- JP 2002313694 A

**Littérature non-brevet citée dans la description**

- **SANG-IN HAN.** Design and Method of Fabricating Phase Shift Masks for Extreme Ultraviolet Lithography by Partial Etching into the EUV Multilayer Mirror. *Proceedings of SPIE,* 2003, vol. 5037